# EUROPEAN PATENT APPLICATION

(11) **EP 1 316 847 A1**
(43) Date of publication of application: **04.06.2003**
(21) Application number: 01830740.5
(22) Date of filing: 30.11.2001
(51) Int. Cl.: G03F 7/20

(54) **"Machine for the uv exposure of flexographic plates"**

(71) Applicant: Degraf s.r.l., 20090 Pieve Emanuelle Mi (IT)
(72) Inventor: De Caria, Riccardo, 20089 Basiglio MI (IT)
(74) Representative: Concone, Emanuele

(57) **Abstract**

A machine for exposing a flexographic plate (1) to the UV rays emitted by a series of UV tubes (2) includes sensor means suitable to detect the power of emission of each of the tubes (2) and a control unit (4) suitable to control the operating time of each tube (2) according to the power detected by the sensor means. It further includes also a display (5) connected to the control unit (4) to display the number of a tube to be replaced in case of failure or decline of the performance below a preset threshold.

## Description

The present invention relates to machines for the treatment of flexographic plates, and in particular to a machine for exposing the plates to UV rays for the photopolymerization process.

It is known that in modern techniques for manufacturing flexographic plates there are used plates consisting of a monomer coated by a thin carbon surface layer which by means of a laser beam is removed at the areas where you wish to obtain the image to be printed.

After having been engraved by the laser, the plate is exposed to a source of UV-A rays which cause the polymerization of the monomer only at the areas where the carbon layer has been removed, whereas said layer prevents the polymerization of the rest of the plate. The plate is then washed with a specific solvent which, helped by the mechanical action of rotating brushes, removes from the plate the non-polymerized material thus leaving only the image to be printed. The procedure is then completed by a plate drying, and a second and third exposure to UV-A (350-400 nm) and UV-C (253,7 nm) rays respectively in order to complete the in-depth polymerization of the plate and to eliminate its surface tackiness.

For these exposures there are usually used fluorescent tubes emitting UV light in the indicated spectrum and having a very small power in mW/cm². In order to minimize the plate exposure time there is normally mounted a series of tubes as close as possible which, depending on the plate size, may reach even 50 units.

This step of the manufacturing process is particularly critical in that the plate quality largely rests on a perfect exposure, i.e. on the uniformity of irradiation and on the correct calculation of the exposure time.

Present machines have problems in controlling the exposure both as to uniformity and to time calculation. In fact, if the exposure is incorrect the plate may be not perfectly polymerized even though at first sight the operator is unable to detect any defect. However, the imperfection comes to light when the plate is mounted on the printing machine with a subsequent heavy economical loss for the printer.

This is a consequence of the fact that the fluorescent tubes have an initial period of emission at maximum power whereafter they start to decay and lose power until they are exhausted. Moreover, even when they have just been installed it is possible to have a certain difference in power between one tube and another with respect to the nominal power, and also the performance decline is not uniform.

As a consequence if the emission is not uniform between one tube and another it is not possible to achieve a perfect uniformity of polymerization of the plate. Furthermore if with the initial emission of, for example, 20 mW/cm² the correct exposure time is 600 seconds, as the tubes decay it will be more and more difficult to calculate a correct exposure time.

Therefore the object of the present invention is to provide a machine for exposing the flexographic plates to UV rays which overcomes all the above-mentioned drawbacks.

This object is achieved by means of a machine provided with sensor means for detecting the irradiation power of each tube and with control means which use the data obtained through said sensors to control the exposure time.

A first fundamental advantage of the present machine is exactly that of automating the calculation of the exposure time thus allowing to make up for the differences in power between one tube and another by changing the operating time of each tube.

A second significant advantage of the present machine is that it allows the maximum exploitation of the life of each tube, indicating to the operator when it needs replacement because its power has dropped below a preset threshold.

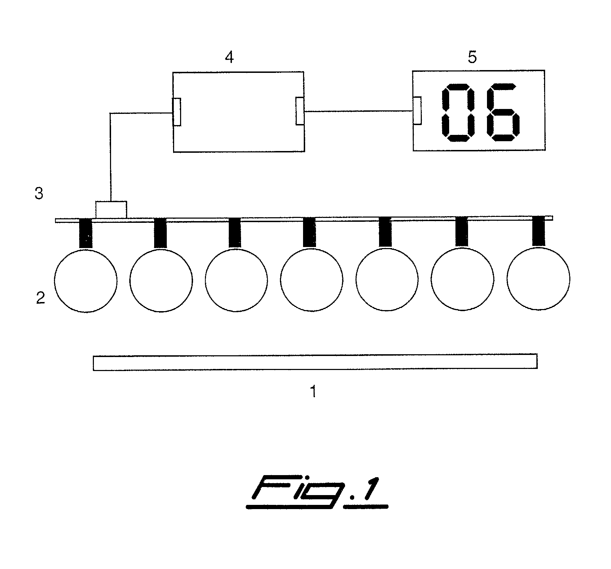

These and other advantages and characteristics of the UV exposure machine according to the present invention will be clear to those skilled in the art from the following detailed description of an embodiment thereof with reference to the only drawing, annexed as fig.1, which diagrammatically illustrates the exposure control system.

With reference to said figure, there is seen that a machine according to the invention conventionally includes a series of UV-A and UV-C tubes 2 parallelly arranged, below which there is placed a plate 1 which must undergo photopolymerization.

The novel aspect of the present machine essentially consists in a board 3 provided with phototransistors sensitive to UV-A and UV-C rays, spaced apart by a distance equal to the distance between the centers of tubes 2 and arranged above them.

The phototransistors board 3 is also connected to a control unit 4 which receives the reading of the power emitted by each tube and constantly processes it thus providing the control of the exposure time of each individual tube. For example, if the preset exposure time is 600 seconds for a tube at 100% efficiency and a certain tube only has a 70% efficiency than said tube will be switched off after 780 seconds so that the total irradiated power is the same.

In practice, when the tubes have just been installed a program will check the emission power of each tube and will take the most powerful tube as a reference so as to automatically increase the exposure time of the other tubes.

Moreover there is provided a display 5 through which the control unit 4 can indicate to the operator the number of the tube to be replaced when the efficiency of said tube drops below a preset threshold, for example 30% with respect to the initial efficiency, or when it fails completely.

It is clear that the above-described and illustrated embodiment is just an example susceptible of various modifications. For example, the relative arrangement of the various elements 2, 3, 4 and 5 may be somewhat changed especially depending on the number and size of the tubes which may also be arranged not mutually parallel.

## Claims

1. A machine for exposing a flexographic plate (1) to the UV rays emitted by a series of UV tubes (2), **characterized in that** it includes at least one sensor means suitable to detect the power of emission of said UV tubes (2), said at least one sensor means being functionally connected to a control unit (4) suitable to control the operating time of the tubes (2) according to the power detected by the sensor means.

2. A machine according to claim 1, **characterized in that** it includes a plurality of sensor means which detect the power of emission of each tube (2) individually and **in that** the control unit (4) controls the operating time of each tube (2) individually.

3. A machine according to claim 1 or 2, **characterized in that** the sensor means are phototransistors.

4. A machine according to one or more of the preceding claims, **characterized in that** the phototransistors are mounted on a board (3).

5. A machine according to claim 4, **characterized in that** the phototransistors are mounted on the board (3) spaced apart by a distance equal to the distance between the centers of the tubes (2) which are arranged mutually parallel.

6. A machine according to one or more of the preceding claims, **characterized in that** it further includes a display (5) functionally connected to the control unit (4) to display the number of a tube to be replaced.
